# EUROPEAN PATENT SPECIFICATION

(11) **EP 0 300 433 B1**
(45) Date of publication and mention of the grant of the patent: **02.05.2001**
(21) Application number: 88111617.2
(22) Date of filing: 19.07.1988
(51) Int. Cl.: H01L 21/18

(54) **Method for manufacturing bonded semiconductor body**
Verfahren zum Herstellen eines Halbleiterverbundkörpers
Procédé pour fabriquer un corps semi-conducteur composé

(30) Priority: 24.07.1987 JP 18351887
(43) Date of publication of application: 25.01.1989
(73) Proprietor: KABUSHIKI KAISHA TOSHIBA, Kawasaki-shi, Kanagawa-ken 210-8572 (JP)
(72) Inventor: Hoshi, Tadahide, 1-1 Shibaura 1-chome Minato-ku Tokyo 105 (JP)
(74) Representative: Henkel, Feiler, Hänzel

(56) References cited:
- EP-A- 0 161 740
- EP-A- 0 190 508
- EP-A- 0 190 935
- Surface roughness-Definitions and Designations JISB 0601 pp15-38

## Description

This invention relates to a method for manufacturing bonded semiconductor bodies, and more particularly to a method for manufacturing semiconductor bodies by directly bonding silicon substrates together, or directly bonding a substrate of Si, GaAs or other semiconductor material with a substrate of the same material or different semiconductor material.

With a bonded semiconductor body, pn junctions and heterojunctions, which have been considered difficult to form in a prior art can be easily formed in a short period of time. For example, in order to form a pn junction of n⁻-type and p⁻-type layers having a thickness of 50 to 100 µm, the cost will be high when conventional epitaxial method is used, and it takes as long as three to ten days if a triple diffusion method is used. However, the pn junction can be obtained in a period of as short as two hours by directly bonding the n⁻-type and p⁻-type layers together.

According to a conventional method for manufacturing the bonded semiconductor body, the both surfaces of Si substrates 1 and 2, facing at bonding interface 3, are cleaned and polished to make a mirror surface with a surface roughness (maximum height) of less than 500 Å. The mirror surfaces are physically brought into contact with each other in a clean atmosphere with no dust, and then the two substrates are subjected to a heat treatment at a temperature of higher than 200°C, normally at a temperature of 1100°C, for two hours in an N₂ gas atmosphere so as to increase the chemical bonding strength between the two substrates (Japanese Patent Disclosure 60-51700 and U.S. Patent Application No. 824,100 which was filed on Jan. 30, 1986 and is now abandoned).

With such a bonded semiconductor body (4), the bonding strength between the two contacted substrates prior to the heat treatment is approx. 5 kg/cm², but the bonding strength can be increased to 100 kg/cm² after the heat treatment. The outer surface of the bonded semiconductor body, which is different from the bonded surface, is subjected to rough polishing and finish polishing in this order, and then semiconductor elements and electrodes are formed in and on the bonded semiconductor body in the same manner as in case of using a single semiconductor substrate.

In the above conventional method for manufacturing the bonded semiconductor body, if dust remains the bonding surface prior to the step of contacting or adhering the two substrates, the two mirror surfaces cannot be adhered in a good contact condition and void will occur between them. It is well known in the art that concentric interference fringes are detected around the dust when the bonded semiconductor body having such voids due to dust is observed by use of infrared topography [which is disclosed in the technical report of disclosure 85-6424 issued from Japanese Patent Association (HATSUMEI KYOUKAI)]. Conventionally, a bonded semiconductor body (4) having the above-mentioned large bonding strength (100 kg/cm²) can be obtained in a manner that a pair of semiconductor wafers, each having less than 500 Å of a surface roughness and less than 5 µm of a total thickness variation range for the bonding area, are prepared, and they are contacted with each other in a clean atmosphere condition by which an interference fringe of voids due to dust can be removed.

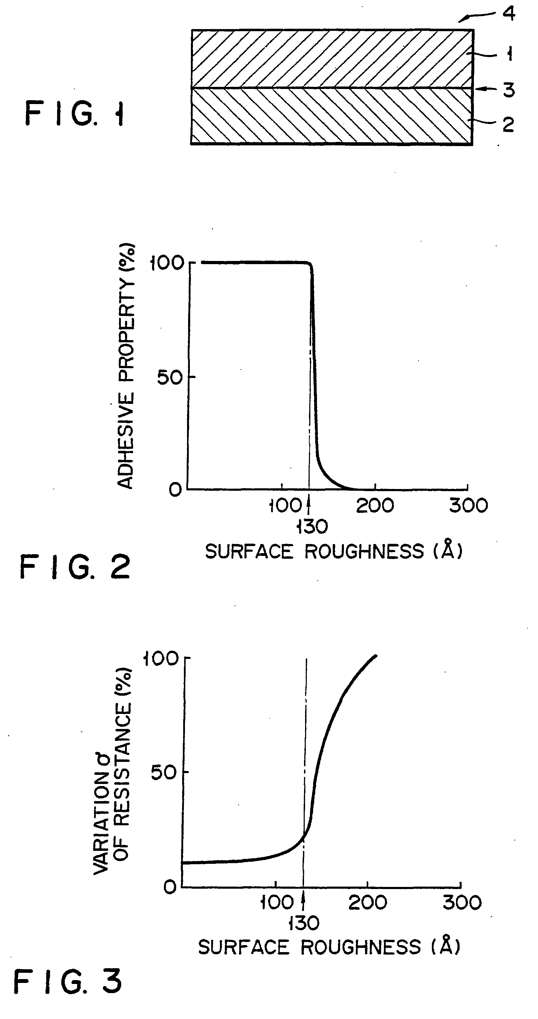

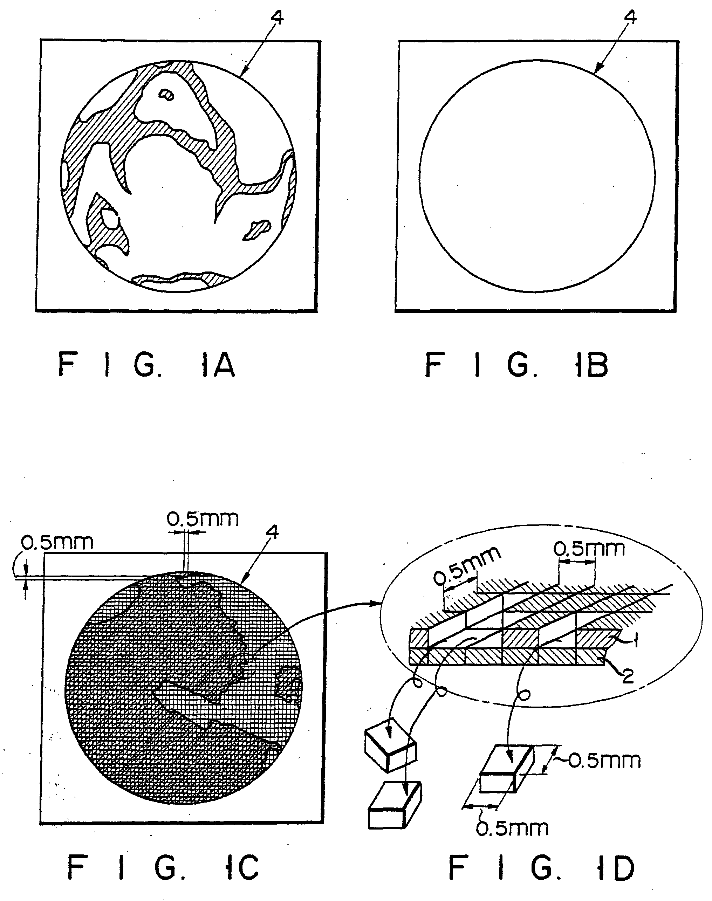

The inventor of the present patent application has known that when bonded semiconductor body 4 obtained by the above manner is observed by the infrared topography, dark portions like the surface of the moon or Mars may sometimes be observed, as is shown in Fig. 1A. However, at present, the inventor does not know anyone who has investigated a specific relation between the dark portions as shown in Fig. 1A and defect of the resultant bonded semiconductor body. This is probably because the dark portions like the surface of Mars disappear after suitable heat treatment, as is shown in Fig. 1B and, after such heat treatment, the final product of bonded semiconductor body 4 has a large bonding strength as mentioned above.

Thus, at present, no one knows what advantages can be obtained by removing the above-mentioned dark portions like the surface of Mars. Of course, no one knows how to determine the surface roughness of the semiconductor wafers in order to remove the dark portions before applying a heat treatment. In the prior art, the dark portions have not been considered as a defective factor in association with the surface roughness.

The defect of the bonded semiconductor body can be found after the final product of the bonded semiconductor body, on which many circuit elements are formed, is diced into small pieces or chips. Bonded semiconductor body 4 shown in Fig. 1B seems to be non-defective. Many circuit elements are formed on body 4 and then body 4 is diced into small chips (0.5 × 0.5 mm or 0.5 mm□). Fig. 1C shows an example of the resultant diced body 4 (observed by photograph, not by infrared topography).

In the illustration of Fig. 1C, the vertical and horizontal lines indicate the dicing lines with pitch of 0.5 mm, and the slant lines indicate the defective portions in which parts of bonded 0.5 mm□ chips are peeled off from their bonding interfaces, as is shown in Fig. 1D. Even if such peeling off does not happen, insufficient bonding of the chips causes to abnormally increase the electrical resistance thereof and, therefore, such chips are also defective. In critical cases, bonded semiconductor body 4 itself is cracked and broken during the process of polishing or manufacturing the device (dicing).

Prior art document EP-A-0 190 935 discloses a method of manufacturing semiconductor devices using a bonding process. In this method, mirror-polished surfaces of two impurity-doped layers of first and second semiconductor substrates are brought into contact with each other at a temperature of not less than 200°C so as to bond them together. The surface roughness of the mirror-polished surface is preferably 500 Å or less, and in the case of an Si substrate, the annealing temperature is preferably 1000°C to 1200°C.

It is an object of this invention to provide a method for manufacturing bonded semiconductor bodies which can be free of problems that the electrical resistance becomes high in some locations of the bodies and the crack or breakage will occur in the polishing step or device forming step, thus attaining a high yield.

Another object of this invention is to provide a method for manufacturing bonded semiconductor bodies which can provide substantially uniform image when observed by use of infrared topography.

To solve this object the present invention provides a method as specified in claim 1.

The method for manufacturing bonded semiconductor bodies comprises the steps of bringing the mirror surfaces of semiconductor substrates of the same type or different types, which may be chemical compound semiconductor substrate of GaAs, InP or GaP, silicon substrates and germanium substrates, into close contact with each other; and then subjecting the semiconductor substrates to a heat treatment at a temperature of higher than 200°C to bond the contacted mirror surfaces together. In this manufacturing method, the surface roughness of the mirror surfaces of the semiconductor substrates used is set equal to or less than 130 Å in its maximum height for a measured range of 1 mm which is the length defined on a reference plane provided in a predetermined area on the mirror surface.

If the surface roughness is set less than 130 Å in its maximum height for the measured range of 1 mm on the reference plane provided in an area to be observed, dark portions like a sea in the surface of the moon or Mars will not appear in the image observed by use of infrared topography.

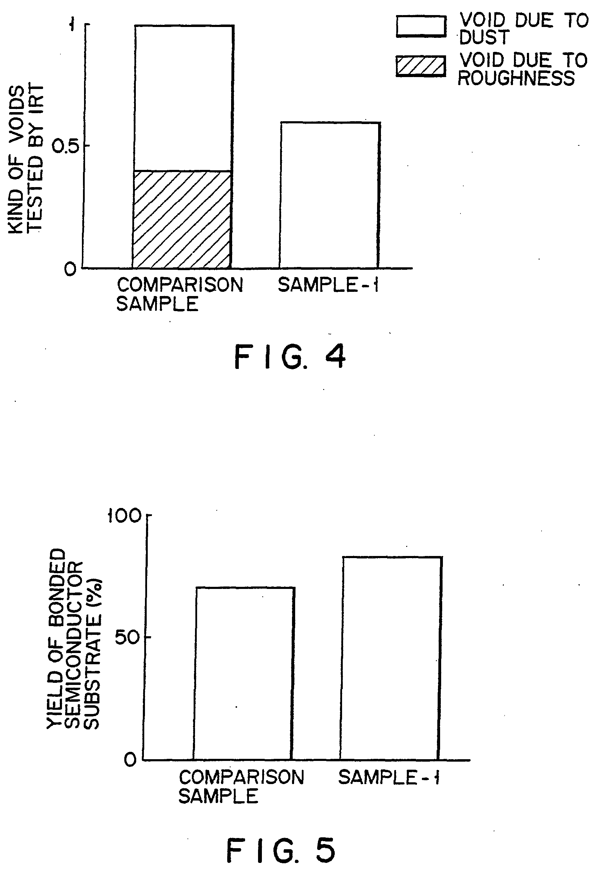

Next, semiconductor substrates having the surface roughness (maximum magnitude between the top and bottom) in the range of 50 to 300 Å were prepared, a plurality of pairs of semiconductor substrates having the same surface roughness were bonded with each other to form a plurality of bonded semiconductor bodies, then the bonded semiconductor bodies were subjected to the breakdown test, and the percentage of non-bonded semiconductor substrates in which cracks or breakage occurred were derived as the bonding property (%) for the respective surface roughnesses. Fig. 2 shows the dependency of the bonding property on the surface roughness. As is clearly seen from Fig. 2, the bonding property is abruptly lowered when the surface roughness exceeds 130 Å (indicated by one-dot-dash line).

Further, Aℓ electrodes were formed on each of the same test bonded semiconductor bodies as were used in the test shown in Fig. 2, and diced into 2 mm □ test pieces, and then the resistance of test pieces were measured. In this case, the wafer used for the bonding was a P-type layer with the resistivity of 0.014 to 0.015 Ω·cm. Then, variation σ in the resistances of the diced test pieces was derived as the percentage (%) of the average resistance. Fig. 3 shows the dependency of the resistance variation on the surface roughness. As is clearly seen from Fig. 3, the resistance variation abruptly increases when the surface roughness exceeds 130 Å as in the case of the bonding property shown in Fig. 2.

From the test results described above, it is understood that, if the surface roughness in a range of 1 mm on the reference plane of the surface is set less than 130 Å, said dark portion can be removed from the image observed by use of infrared topography, and the uniformity of the resistance and the bonding property can be significantly improved. That is, the dark portions in the image observed by the infrared topography indicate incomplete contact portion, and the property of the bonded semiconductor body can be significantly improved by setting the surface roughness less than 130 Å.

In this invention, it should be noted that the measured range in the reference plane provided on the surface is set to be 1 mm and set the maximum surface roughness to 130 Å. Further, the total thickness variation (TTV) of the entire surface of the wafer used here is set less than 5 µm.

This invention can be more fully understood from the following detailed description when taken in conjunction with the accompanying drawings, in which:
Fig. 1 is a cross sectional view schematically showing the construction of a bonded semiconductor body;
Fig. 1A is an example illustration of dark portions like the surface of the moon or Mars, which can be seen when a bonded semiconductor body is observed by infrared topography;
Fig. 1B shows the condition of a heat-treated bonded semiconductor body, observed by infrared topography;
Fig. 1C is an example illustration of the bonded semiconductor body which is diced into small chips, wherein the area of the slant lines are defective;
Fig. 1D shows part of the defective area shown in Fig. 1C, wherein parts of the bonded chips are peeled off from their bonding interfaces;
Fig. 2 is a graph showing the relation between the surface roughness and the bonding property of the bonded semiconductor body;
Fig. 3 is a graph showing the relation between the surface roughness and the resistance variation (σ) of the bonded semiconductor body;
Fig. 4 is a graph showing the result of the void test derived by use of infrared topography with respect to comparison samples to which this invention is not applied and samples according to this invention;
Fig. 5 is a graph showing the result of the yield test for bonded semiconductor bodies with respect to comparison samples to which this invention is not applied and samples according to this invention;
Fig. 6 shows the bonding condition of a bonded semiconductor body (sample A) according to-this invention, wherein sample A is diced into 0.5 mm □ pieces and is observed by use of infrared topography;
Figs. 6A to 6C show the results of measurement of the surface roughness in three given points in Fig. 6;
Fig. 7 shows the bonding condition of a bonded semiconductor body (sample B) to which this invention is not applied, wherein sample B is diced into 0.5 mm □ pieces and is observed by use of infrared topography, wherein cross-hatching portion indicates incomplete bonding portions; and
Figs. 7A to 7C show the results of measurement of the surface roughness in three given points in Fig. 7.

There will now be described this invention with reference to samples 1 and 2.

### [Sample-1]

First, more than 500 N-type silicon wafers were prepared, each of which has a diameter of 100 mm and the resistivity of 20 to 30 Ω·cm, each of whose total thickness variation (TTV) is less than 5 µm, and each of whose surface roughness ranges from 30 Å to 280 Å. The measurement of the surface roughness was effected by use of non-bonded surface roughness measuring device, Model "Surfcom 920A" (spot diameter of 1.6 µm) manufactured by Tokyo Seimitsu Co. Ltd., Japan, and the maximum height was measured in five areas on the wafer with a magnification factor of 1,000,000 and a measurement distance of 1 mm. The average of the measurements was used to determine the surface roughness.

Then, 500 wafers having the surface roughness of less than 130 Å were selected as one lot from the originally prepared and measured wafers, and 250 sets of contact wafers were formed by respectively contacting together two wafers selected out of the lot. After this, the 250 sets of contact wafers were subjected to bonding heat treatment at a temperature of 1100°C (lower than the melting point of the wafer) in an N₂ gas atmosphere (the melting point of the Si wafer is approx. 1400°C).

As a comparison sample, 500 wafers whose surface roughness ranges from 30 Å to 280 Å were random prepared, and 250 bonded wafers of the comparison sample were formed in the same manner as in the sample-1.

Fig. 4 shows the state of void of the bonded wafers of the sample-1 and the comparison sample when observed by means of infrared topography. As is seen from Fig. 4, the void in the comparison sample includes void, which is caused by dust and is indicated by interference fringes, and void due to the roughness indicated by dark portions similar to a sea on the moon or Mars. However, the void in the sample-1 includes only void caused by dust and the amount thereof is substantially the same as the comparison sample, and includes no void due to the roughness.

Fig. 5 is a graph showing the yield of bonded semiconductor bodies with respect to the comparison sample and sample-1, both of which have been subjected to the same device forming process. As is clearly seen from Fig. 5, the yield of the sample-1 is higher than that of the comparison sample by 13 %, and it has been determined that the improvement in the yield could be attained because the surface roughness was set less than 130 Å to thereby completely prevent occurrence of crack or breakage of the semiconductor substrates.

Further, it has also been determined that variation in the element characteristics (cf. Fig. 3) relating to the bonding interface in the element of the sample-1 was significantly improved in comparison with that of the comparison sample.

The same tests as that described above were repeatedly performed, and the same results that the surface roughness of 130 Å is critical value were obtained.

At present, wafers with the roughness of less than 130 Å can be easily available from various wafer makers. Further, complete mirror surface wafers with the surface roughness of 130 Å or less can be obtained by use of the polishing method disclosed in the following Japanese documents:

"Papers in the scientific lectures in autumn meeting of "SEIKKI GAKKAI", Showa-56 (1981)" pp 440-451, by Michio Ishikawa.

In the above explanation, the infrared topography is used for observation of the bonding interface.

Also JP-A-62-122 141 details the use of infrared rays to observe a bonding interface.

The technique of bonding two semiconductor wafers by use of heat treatment is disclosed, for example, in US-A-4 671 846 and US-A-4 700 466.

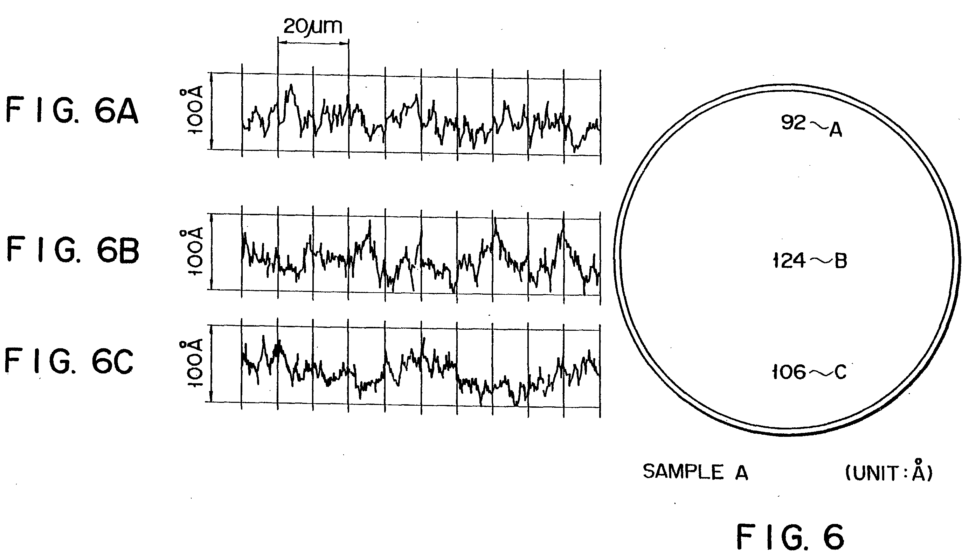

Fig. 6 shows the bonding condition of a bonded semiconductor substrate wafer (sample A) according to this invention. The surface roughness of sample A is less than 130 Å. Sample A is diced into 0.5 mm □ pieces, and is observed by use of infrared topography. Further, Figs. 6A to 6C show the results of measurement of the surface roughness (92 Å, 124 Å, and 106 Å) in three preset points in Fig. 6. Fig. 6 indicates that no void is observed on the entire surface of the wafer.

Incidentally, the white ring illustrated at the outer periphery of the disk-like wafer sample A shown in Fig. 6 indicates a non-bonded area. The width of such a non-bonded area is generally about 2 mm for the wafer of 100 mm φ diameter, and occurrence of such area, due to inevitable round-off at the edge of a disk-like wafer, cannot be avoided in practice. However, such a non-bonded area causes no problem because it is removed during the manufacturing process thereof, and it is not relevant to the content of the present invention.

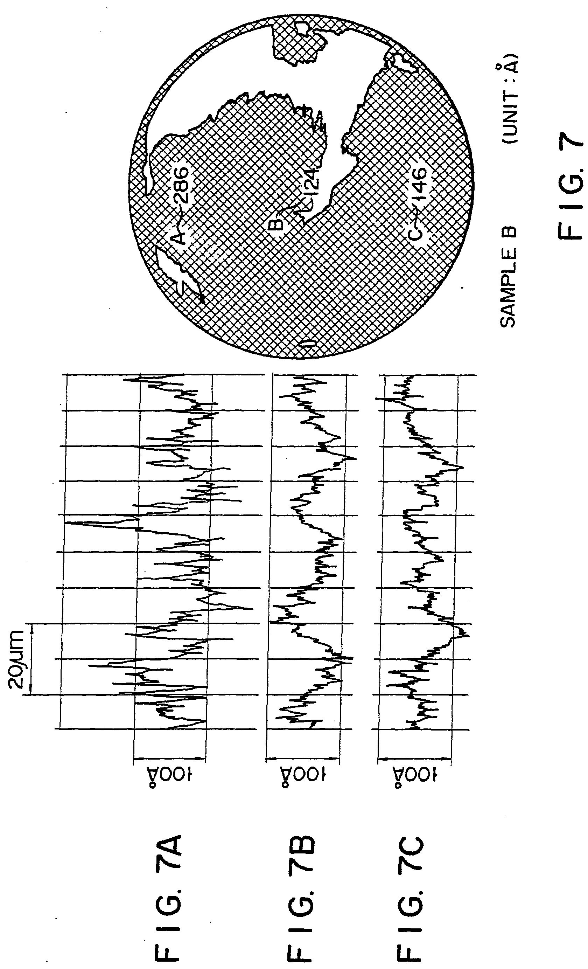

Fig. 7 shows the bonding condition of a bonded semiconductor substrate wafer (sample B) to which this invention is not applied. Sample B includes not only areas having a surface roughness of less than 130 Å, but also those having a surface roughness of more than 130 Å. Sample B is diced into 0.5 mm □ pieces, and is observed by use of infrared topography, wherein a cross-hatching portion indicates incomplete bonding portions. Figs. 7A to 7C show the results of measurement of the surface roughness (286 Å, 124 Å, and 146 Å) in three preset points in Fig. 7. In Fig. 7, the white area indicates that the surface roughness (124 Å) is less than 130 A and there is no void, and the cross-hatching portion indicates that the surface roughness (286 Å and 146 Å) is more than 130 Å and incomplete contact due to void has occurred.

### [Sample-2]

The same test as that described above was effected using a semiconductor substrate of Ge, GaAs, InP, or GaP having the surface roughness around 70 to 80 Å, and the same result as in the sample-1, in which the property is greatly changed with the surface roughnesses of more and less than 130 Å, was obtained.

Accordingly, for manufacturing bonded semiconductor bodies, the surface roughness of the semiconductor substrate prior to the bonding is set less than 130 Å so that incomplete contact due to the roughness of the substrate surface can be effectively prevented. As a result, it becomes possible to significantly reduce the number of defective bonded semiconductor bodies due to substrate crack or breakage. Further, variation in the electrical characteristics in the bonding interface can be sufficiently suppressed, and therefore the element characteristics in the bonded semiconductor body can be made stable.

As described above, the manufacturing method of this invention contributes to low manufacturing cost and increase in yield of chips by use of bonded semiconductor bodies.

## Claims

1. A method for manufacturing a bonded semiconductor body, comprising the steps of:
a) preparing a first semiconductor substrate (1) with a flat mirror surface;
b) preparing a second semiconductor substrate (2) with a flat mirror surface;
c) bringing the mirror surface of said first semiconductor substrate (1) intoclose contact with the mirror surface of said second semiconductor substrate (2) to form a semiconductor body (4);
d) subjecting said semiconductor body (4) to a heat treatment at a temperature equal to or higher than 200° C and lower than the melting point of said first and second semiconductor substrates (1, 2) for a given period of time in a predetermined atmosphere, whereby said bonded semiconductor body is formed;
**characterized** by:
e) providing said flat mirror surfaces of said first and second semiconductor substrates (1, 2) with a surface roughness equal to or less than 13 nm (130 Å) in a range of 1 mm length;
f) observing said semiconductor body (4) by use of infrared topography before said heat treating step for selecting those semiconductor bodies providing an image of uniform intensity, for said heat treatment.

2. A method for manufacturing a bonded semiconductor body, according to claim 1, wherein
the first semiconductor substrate (1) is a Ge, GaAs, InP or GaP substrate;
the second semiconductor substrate (2) ) is a Ge, GaAs, InP or GaP substrate;
and said flat mirror surfaces of said first and second semiconductor substrates (1, 2) have a surface roughness of 7 nm (70 Å) to 8 nm (80 Å) in a range of 1 mm length.

3. A method according to claims 1 or 2, characterized in that the total thickness variation of said first and second semiconductor substrates (1 and 2) is set less than 5 µm on the entire contacted surface thereof.

4. A method according to claims 1 or 2, characterized in that said given period of time is longer than about 2 hours.

5. A method according to claim 1 or 2, characterized in that said predetermined atmosphere is provided by nitrogen gas.

## Patentansprüche

1. Verfahren zum Herstellen eines Halbleiter-Verbundkörpers mit den Schritten:
a) Vorbereiten eines ersten Halbleitersubstrats (1) mit einer ebenen Spiegeloberfläche,
b) Vorbereiten eines zweiten Halbleitersubstrats (2) mit einer ebenen Spiegeloberfläche,
c) Bringen der Spiegeloberfläche des ersten Halbleitersubstrats (1) in engen Kontakt mit der Spiegeloberfläche des zweiten Halbleitersubstrats (2) zum Bilden eines Halbleiterkörpers (4),
d) Unterziehen des Halbleiterkörpers (4) einer Wärmebehandlung bei einer Temperatur, die gleich oder höher als 200°C und niedriger als der Schmelzpunkt der ersten und zweiten Halbleitersubstrate (1,2) ist, für eine vorgegebene Zeitspanne in einer vorbestimmten Atmosphäre, wodurch der Halbleiterverbundkörper gebildet wird,
gekennzeichnet durch:
e) Versehen der ebenen Spiegeloberflächen der ersten und zweiten Halbleitersubstrate (1,2) mit einer Oberflächenrauhigkeit die gleich oder kleiner ist als 13 nm (130 Å) in einem Bereich von 1 mm Länge,
f) Betrachten des Halbleiterkörpers (4) mittels Infrarot-Topographie vor dem Wärmebehandlungsschritt, um diejenigen Halbleiterkörper für die Wämebehandlung auszuwählen, die ein Bild gleichmäßiger Intensität ergeben.

2. Verfahren zum Herstellen eines Halbleiterverbundkörpers gemäß Anspruch 1, wobei
das erste Halbleitersubstrat (1) ein Ge, ein GaAs, ein InP oder ein GaP-Substrat ist,
das zweite Halbleitersubstrat (2) ein Ge, ein GaAs, ein InP oder ein GaP-Substrat ist,
und die ebenen Spiegeloberflächen der ersten und zweiten Halbleitersubstrate (1,2) eine Oberflächenrauhigkeit von 7 nm (70 Å) bis 8 nm (80 Å) in einem Bereich von 1 mm Länge aufweisen.

3. Ein Verfahren gemäß Anspruch 1 oder 2, dadurch gekennzeichnet, daß die Gesamtdickenschwankung der ersten und zweiten Halbleitersubstrate (1 und 2) auf weniger als 5 µm auf der gesamten kontaktierten Oberfläche derselben eingestellt ist.

4. Ein Verfahren gemäß Anspruch 1 oder 2, dadurch gekennzeichnet, daß die vorgegebene Zeitspanne länger als etwa 2 Stunden ist.

5. Ein Verfahren gemäß Anspruch 1 oder 2, dadurch gekennzeichnet, daß die vorbestimmte Atmosphäre durch Nitrogen- bzw. Stickstoffgas geliefert wird.

## Revendications

1. Procédé de fabrication d'un corps semiconducteur lié, comprenant les opérations suivantes :
a) préparer un premier substrat semiconducteur (1) ayant une surface miroir plane ;
b) préparer un deuxième substrat semiconducteur (2) ayant une surface miroir plane ;
c) mettre la surface miroir dudit premier substrat semiconducteur (1) en étroit contact avec la surface miroir dudit deuxième substrat semiconducteur (2) afin de former un corps semiconducteur (4) ;
d) soumettre ledit corps semiconducteur (4) à un traitement thermique sous une température égale ou supérieure à 200°C et inférieure au point de fusion desdits premier et deuxième substrats semiconducteurs (1, 2) pendant une durée donnée, dans une atmosphère prédéterminée, si bien que ledit corps semiconducteur lié est formé :
caractérisé par les opérations suivantes :
e) doter lesdites surfaces miroirs planes desdits premier et deuxième substrats semiconducteurs (1, 2) d'une rugosité superficielle égale ou inférieure à 13 nm (130 Å) sur un intervalle de 1 mm de longueur ;
f) observer ledit corps semiconducteur (4) en utilisant une topographie infrarouge avant ladite opération de traitement thermique afin de sélectionner les corps semiconducteurs produisant une image d'intensité uniforme, pour ledit traitement thermique.

2. Procédé de fabrication d'un corps semiconducteur lié, selon la revendication 1, où :
le premier substrat semiconducteur (1) est un substrat de Ge, GaAs, InP ou GaP ;
le deuxième substrat semiconducteur (2) est un substrat de Ge, GaAs, InP ou GaP ; et
lesdites surfaces miroirs planes desdits premier et deuxième substrats semiconducteurs (1, 2) ont une rugosité superficielle de 7 nm (70 Å) à 8 nm (80 Å) sur un intervalle de 1 mm de longueur.

3. Procédé selon la revendication 1 ou 2, caractérisé en ce que la variation d'épaisseur totale desdits premier et deuxième substrats semiconducteurs (1 et 2) est fixée à moins de 5 µm sur toute leur surface en contact.

4. Procédé selon la revendication 1 ou 2, caractérisé en ce que ladite durée donnée est plus longue que 2 h environ.

5. Procédé selon la revendication 1 ou 2, caractérisé en ce que ladite atmosphère prédéterminée est fournie par le gaz azote.
